**Europäisches Patentamt**

**European Patent Office**

**Office européen des brevets**

(19)

(11) Publication number : **0 365 268 B1**

(12) **EUROPEAN PATENT SPECIFICATION**

(45) Date of publication of patent specification :
07.09.94 Bulletin 94/36

(51) Int. Cl.$^5$ : **H03H 9/19**, H03H 9/05

(21) Application number : 89310636.9

(22) Date of filing : 17.10.89

(54) **Length longitudinal resonator.**

(30) Priority : **17.10.88 JP 262536/88**

(43) Date of publication of application :
**25.04.90 Bulletin 90/17**

(45) Publication of the grant of the patent :
**07.09.94 Bulletin 94/36**

(84) Designated Contracting States :
**CH DE GB LI**

(56) References cited :
**EP-A- 0 343 000
PATENT ABSTRACTS OF JAPAN, vol. 10, no.
82 (E-392)[2139], 2nd April 1986; & JP-A-60 226
205
PATENT ABSTRACTS OF JAPAN, vol. 9, no. 89
(E-309)[1812], 18th April 1985; & JP-A-59 218
022
PATENT ABSTRACTS OF JAPAN, vol. 4, no. 87
(E-16)[569], 21st June 1980, page 10 F 16; &
JP-A-5552621
PATENT ABSTRACTS OF JAPAN, vol. 8, no.
221 (E-271)[1658], 9th October 1984; & JP-A-59
104 812**

(73) Proprietor : **SEIKO ELECTRONIC
COMPONENTS LTD.
30-1, Nishitaga 5-chome,
Taihaku-ku
Sendai-shi, Miyagi-ken 982 (JP)**

(72) Inventor : **Kimura, Fumio SEIKO ELECTRONIC
COMPONENTS LTD.
30-1 Nishitaga 5-chome
Taihaku-ku
Sendai-shi Miyagi-ken (JP)**
Inventor : **Oizumi, Masahiro SEIKO
ELECTRONIC COMPONENTS LTD.
30-1 Nishitaga 5-chome
Taihaku-ku
Sendai-shi Miyagi-ken (JP)**

(74) Representative : **Miller, Joseph et al
J. MILLER & CO.
34 Bedford Row,
Holborn
London WC1R 4JH (GB)**

# Description

This invention concerns a length longitudinal quartz crystal or other piezo-electric resonator, e.g. for use in information instruments and communication instruments such as microcomputers, wireless telephones and facsimile machines.

A length longitudinal piezo-electric resonator is known having a vibrational section and a frame section surrounding the vibrational section, the resonator being mounted in a container. In the operation of the known resonator, however, an overall vibration of the container is liable to cause extreme instability of the equivalent series resistence of the resonator, especially when external mechanical stress is applied to the container.

According, therefore, to the present invention, there is provided a length longitudinal piezo-electric resonator, such as that disclosed in EP-A- 0 343 000 which is a document as described by Article 54(3)EPC and hence may not be referred to when considering the inventive step (Article 56EPC) of the subject-matter defined by the present application, having a vibrational section and a frame section surrounding the vibrational section characterised in that the vibrational section has an oscillating frequency in the range of 1.04 MHz to 1.06 MHz; the frame section has an overall length of 4000 microns ± 200 microns; and there are means for maintaining a transverse distance between the vibrational section and the frame section in the range of 50 microns to 140 microns.

Preferably, the said means comprises a pair of supporting sections connected transversely between the vibrational section and parts of the frame section, the said distance being consituted by the transverse length of each supporting section.

Preferably, the frame section comprises a pair of longitudinal subsections, a transverse subsection connecting the longitudinal subsections at one of their ends, and a mounting subsection connected to the longitudinal subsections at their opposite ends.

The resonator is preferably formed of an integrally etched quartz crystal plate.

The resonator may be mounted within a container.

The invention is illustrated, merely by way of example, in the accompanying drawings in which:-

Figure 1 is a plan view of a resonator according to the present invention;

Figure 2 is a sectional view of a container containing a resonator according to the present invention;

Figure 3 is a schematic diagram illustrating the relationship between frame flexural vibration and energy loss of a resonator according to the present invention;

Figure 4 is a characteristic graph indicating the relationship between variations in the value of R1 due to pressure application and the length D of supporting sections of the resonator, and

Figure 5 is a histogram showing the distribution of the amount of variation of R1 with respect to prior art resonators and to resonators according to the present invention.

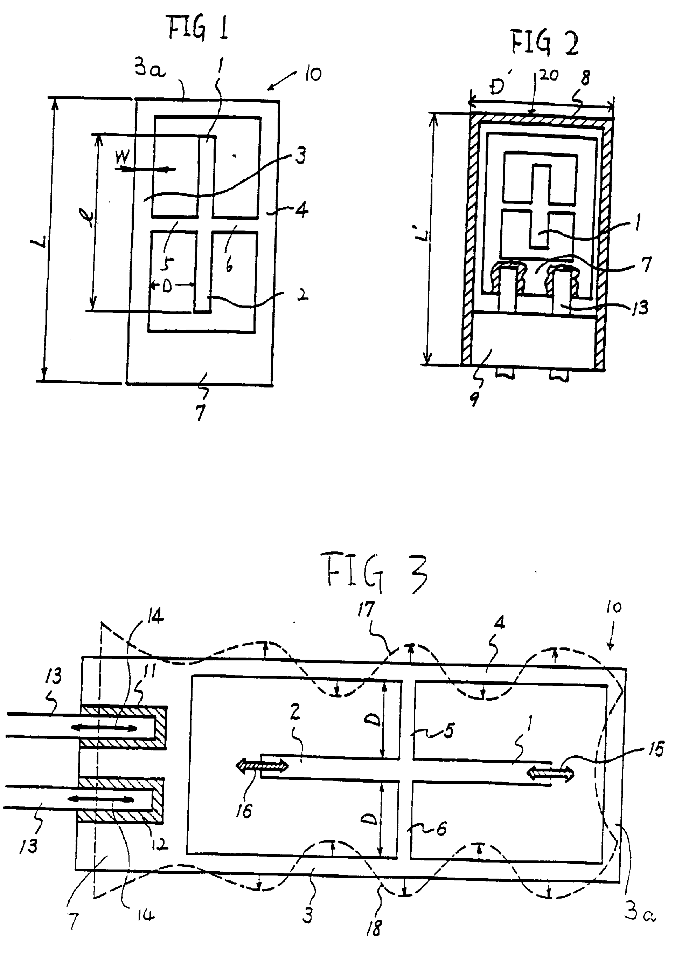

In Figure 1 there is shown a quartz crystal, piezo-electric, length longitudinal resonator 10 according to the present invention. As shown, the resonator 10 is composed of a vibrational section 1, 2 and a frame section 3, 3a, 4, 7 which integrally includes a mounting section 7. The vibrational section 1, 2, and the frame section 3, 3a, 4, 7 are formed integrally with each other through a pair of supporting sections 5 and 6. Moreover, the vibrational section 1, 2 is surrounded by the frame section 3, 3, 4, 7. The components so far described constitute the basic structure of the length longitudinal resonator 10.

Figure 2 shows an encapsulating structure which encapsulates the length longitudinal resonator 10. The encapsulation preferably comprises a metal container 20 having a diameter D′ of 2mm and a length L′ of 6mm. As shown in Figure 2, the container 20 is comprised of a cap 8 and a stem 9 and contains a length longitudinal resonator 10 of the kind shown in Figure 1. A pair of lead rods 13 are fixed to the mounting section 7 of the resonator 10 by soldering or electro-conductive adhesive. The length longitudinal resonator 10 has an oscillating frequency f determined by the length $\ell$ of the vibrational section 1, 2 according to the following equation:-

$$f \, [KHz] = 2740 \, [KHz \, mm]/\ell \, [mm] \quad (1)$$

The dimensions of the container 20 shown in Figure 2 are those generally adopted in the market, and therefore the length dimension L of the resonator 10 is accordingly determined to be L=4000 microns ± 200 microns.

Figure 3 shows the vibration modes of the various parts of the resonator 10. The resonator 10 is comprised of the vibrational section 1, 2 composed of a pair of longitudinally aligned subsections 1 and 2; the frame section 3, 3a, 4, 7 having a pair of longitudinal and parallel subsections 3 and 4 connected at one of their ends to the mounting section 7 and connected at their opposite ends to each other through a transverse connecting subsection 3a; and the pair of supporting sections 5 and 6 extending transversely from and in opposite directions from their junction with the pair of longitudinally aligned subsections 1 and 2, the supporting sections 5, 6 being connected to the respective longitudinal and parallel subsections 3 and 4. The length longitudinal resonator 10 undergoes a longitudinal vibrational displacement at the vibrational section 1, 2 as shown by the arrows 15 and 16. This vibrational displacement induces a flexural vibration 17, 18 in the frame section 3, 3a, 4, 7 through the supporting sections 5 and 6 as indicated by the broken line.

The pair of lead rods 13 are coupled to the mounting section of the resonator 10 at a pair of mounting pads 11 and 12. This induced flexural vibration 17, 18 is transmitted through the frame section 3, 3a, 4, 7 and the mounting pads 11 and 23 so as to induce subsequent vibration 14 of the lead rods 11 and 12. This phenomemon is capable of finally causing an overall vibration of the container 20 including the cap 8 and the stem 9, thereby causing extreme instability of the equivalent series resistance R1 characteristic could become extremely susceptable to external mechanical stress applied to the container 20. This phenomenon is called structural energy loss. If the structural energy loss is great, the R1 characteristic can become unstable in relation to the application of mechanical pressure. Such an energy loss must therefore be reduced to improve the performance of the resonator.

It is of course always desirable to reduce the energy loss of any type of resonator. However, with regard to a resonator of the length longitudinal type, since the flexural vibration caused in the frame section 3, 3a, 4, 7 has a complicated relationship with the energy loss, theoretical and experimental analysis thereof has not previously been effectively undertaken, thereby causing a serious problem in relation to the resonator. That is to say, there have not previously been proposed quantitative and numerical factors and dimensions of the resonator configuration effective to reduce the instability of the R1 characteristic.

Figure 4 is a characteristic diagram or graph which illustrates the relationship between the transverse distance D between one of the longitudinal subsections 3, 4 of the frame section 3, 3a, 4, 7 and the adjacent part of the vibrational section 1, 2 and a changing or shifting in the value of the R1 characteristic due to the application of external pressure or stress to the container 20. As shown in Figure 3, the distance D is identical to the transverse length of each of the supporting sections 5, 6. The abscissa of the graph of Figure 4 indicates the distance D and the ordinate thereof indicates the changing rate $\gamma$ of the characteristic R1 with respect to the application of the pressure, as defined by the following:

$$\gamma = R1'/R1 =$$

$$\frac{\text{Value of R1 measured in the presence of external pressure}}{\text{Value of R1 measured in the absence of external pressure}}$$

where R1′ is determined as the maximum value obtained during variation of the magnitude of the mechanical pressure applied to the resonator container 20.

In the graph of Figure 4, the value of $\gamma$ increases substantially linearly when the distance D increases in the range of $D \geqq 150$ microns. Namely in this range, it is found that the degree of the energy loss increases in proportional to the length D of each supporting section 5, 6. On the other hand, in the range of $D \leqq 140$ microns the value of $\gamma$ is about 1.5 and is constant.

Namely, it is found that the energy loss does not depend on the dimension D in this range of $D \leqq 140$ microns.

However, the resonator 10 may be formed by photo-lithographic etching of a thin plate of quartz crystal, and therefore the length D of each supporting section 5, 6 must be set at a value suitable to enable the etching to be carried out. In view of this, the length D is set to at least 50 microns so as to provide the critical clearance required in etching process technology.

According to the above described experimental results and in view of the processing limitation, the supporting section length D is set in order to reduce the energy loss as follows:-

$$50 \leqq D \leqq 140 \text{ (microns)} \quad (2)$$

By setting the value of D as above, a length longitudinal resonator 10 can have a reduced structural energy loss in the frequency range of 1.04 MHz - 1.06 MHz i.e., it can reduce the instability of the R1 characteristic due to the application of external pressure.

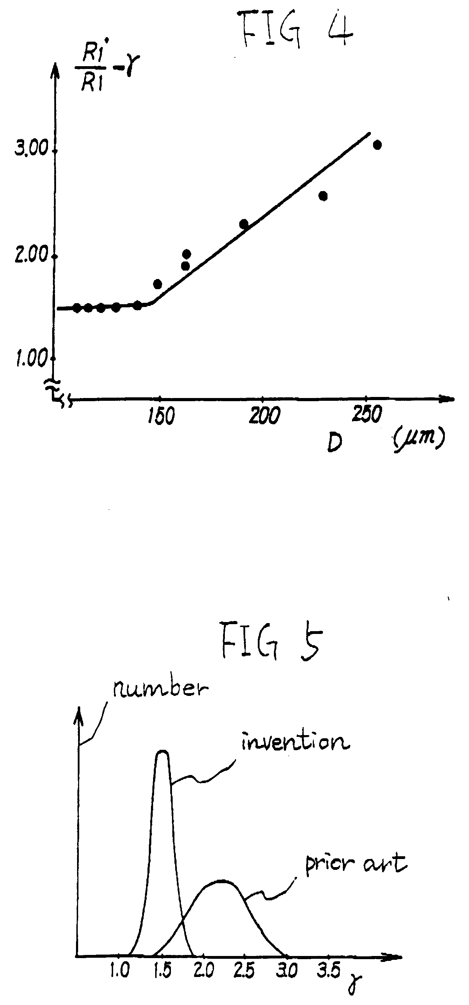

Figure 5 shown the distribution of the changing rate $\gamma$ in the case of resonators of the present invention and of the prior art respectively. The abscissa of the graph of Figure 5 indicates the value of $\gamma$ in the same manner as the ordinate of the graph of Figure 4. The ordinate of the graph of Figure 5 indicates a number of samples to define a historgram. As is apparent from Figure 5, in the case of the prior art resonators of the present invention, the value of $\gamma$ ranges from more than 1.0 to less than 2.0, thereby confirming that the rate of change is extremely reduced. Since the value of R1 in the absence of pressure is about 300 ohms to 600 ohms, the value of R1 changes up to about 1.2k ohms in the presence of pressure when applied to a resonator according to the present invention. Such a degree and amount of the increase in R1 do not substantially affect the practical performance, and the etching clearance width of 50 microns is sufficient to enable industrial mass-production of the resonators to be effected.

## Claims

1. A length longitudinal piezo-electric resonator having a vibrational section (1,2) and a frame section (3, 3a, 4, 7) surrounding the vibrational section (1,2) characterised in that the vibrational section (1,2) has an oscillating frequency in the range of 1.04 MHz to 1.06 MHZ; the frame section (3, 3a, 4, 7) has an overall length (L) of 4000 microns $\pm$ 200 microns; and there are means (5,6) for maintaining a transverse distance (D) between the vibrational section (1,2) and the frame section (3, 3a, 4, 7) in the range of 50 microns to 140 microns.

2. A length longitudinal piezo-electric resonator as claimed in claim 1 characterised in that the said means (5,6) comprises a pair of supporting sections (5,6) connected transversely between the vibrational section (1,2) and parts (3,4) of the frame section (3, 3a, 4, 7), the said distance being constituted by the transverse length (D) of each supporting section (5,6).

3. A length longitudinal piezo-electric resonator as claimed in claim 1 or 2 characterised in that the frame section (3, 3a, 4, 7) comprises a pair of longitudinal subsections (3, 4), a transverse subsection (3a) connecting the longitudinal subsections (3,4) at one of their ends, and a mounting subsection (7) connected to the longitudinal subsections (3, 4) at their opposite ends.

4. A length longitudinal piezo-electric resonator as claimed in any preceding claim characterised in that the resonator is formed of an integrally etched quartz crystal plate.

5. A length longitudinal piezo-electric resonator as claimed in any preceding claim characterised in that the resonator (10) is mounted within a container (20).

## Patentansprüche

1. Piezoelektrischer Längsdehnungsschwinger, der einen Schwingungsabschnitt (1,2) und einen den Schwingungsabschnitt (1,2) umgebenden Rahmenabschnitt (3,3a,4,7) aufweist, **dadurch gekennzeichnet,** daß der Schwingungsabschnitt (1,2) eine Schwingungsfrequenz im Bereich von 1.04 MHz bis 1.06 MHz aufweist; der Rahmenabschnitt (3,3a,4,7) eine Gesamtlänge (L) von 4000 Mikrometern ± 200 Mikrometern aufweist; und Mittel (5,6) vorgesehen sind zum Aufrechterhalten eines Querabstands (D) zwischen dem Schwingungsabschnitt (1,2) und dem Rahmenabschnitt (3, 3a, 4, 7) im Bereich von 50 Mikrometern bis 140 Mikrometern.

2. Piezoelektrischer Längsdehnungsschwinger nach Anspruch 1, **dadurch gekennzeichnet,** daß das Mittel (5,6) ein Paar von Tragabschnitten (5,6) umfaßt, die quer zwischen dem Schwingungsabschnitt (1,2) und Teilen (3,4) des Rahmenabschnitts (3,3a,4,7) angeordnet und mit diesen jeweils verbunden sind, wobei der Abstand durch die Querlänge (D) jedes Tragabschnitts (5,6) gebildet ist.

3. Piezoelektrischer Längsdehnungsschwinger nach Anspruch 1 oder 2, **dadurch gekennzeichnet,** daß der Rahmenabschnitt (3,3a,4,7) ein Paar von Längs-Unterabschnitten (3,4), einen die Längs-Unterabschnitte (3,4) an einem ihrer Enden verbindenden Quer-Unterabschnitt (3a), und einen mit den Längs-Unterabschnitten (3,4) an ihren entgegengesetzten Enden verbundenen Befestigungs-Unterabschnitt (7) umfaßt.

4. Piezoelektrischer Längsdehnungsschwinger nach einem der vorhergehenden Ansprüche, **dadurch gekennzeichnet**, daß der Schwinger aus einer einteilig geätzten Quarzkristallplatte gebildet ist.

5. Piezoelektrischer Längsdehnungsschwinger nach einem der vorhergehenden Ansprüche, **dadurch gekennzeichnet**, daß der Schwinger innerhalb eines Behälters (20) angebracht ist.

## Revendications

1. Résonateur piézo-électrique allongé longitudinalement ayant une section vibratoire (1, 2) et une section de cadre (3, 3a, 4, 7) entourant la section vibratoire (1, 2), caractérisé en ce que la section vibratoire (1, 2) a une fréquence oscillatoire dans l'intervalle allant de 1,04 MHz à 1,06 MHz; la section de cadre (3, 3a, 4, 7) a une longueur totale (L) de 4000 microns ± 200; et des moyens (5, 6) sont prévus pour maintenir une distance transversale (D) entre la section vibratoire (1, 2) et la section de cadre (3, 3a, 4, 7) dans l'intervalle de 50 microns à 140 microns.

2. Résonateur piézo-électrique allongé longitudinalement selon la revendication 1, caractérisé en ce que ledit moyen (5, 6) comprend une paire de sections de support (5, 6) connectées transversalement entre la section vibratoire (1, 2) et des parties (3, 4) de la section de cadre (3, 3a, 4, 7), ladite distance étant constituée par la longueur transversale (D) de chaque section de support (5, 6).

3. Résonateur piézo-électrique longitudinal allongé selon la revendication 1 ou 2, caractérisé en ce que la section de cadre (3, 3a, 4, 7) comprend une paire de sous-sections longitudinales (3, 4), une sous-section transversale (3a) connectant les sous-sections longitudinales (3, 4) à une de leurs extrémités et une sous-section de montage (7) connectée aux sous-sections longitudinales (3, 4) à leurs extrémités opposées.

4. Résonateur piézo-électrique longitudinal allongé selon l'une quelconque des revendications précédentes, caractérisé en ce que le résonateur est formé d'une plaque de cristal de quartz d'une seule pièce et qu'il est réalisé par attaque chimique.

5. Résonateur piézo-électrique allongé longitudinalement selon l'une quelconque des revendications précédentes, caractérisé en ce que le résonateur (10) est monté dans un récipient (20).

FIG 1

FIG 2

FIG 3

FIG 4

FIG 5